(19) Europäisches Patentamt

European Patent Office

Office européen des brevets

(11) Publication number: **0 238 989 B1**

(12) **EUROPEAN PATENT SPECIFICATION**

(45) Date of publication of patent specification: **03.06.92** (51) Int. Cl.⁵: **H01H 13/70**, H03K 17/975

(21) Application number: **87103933.5**

(22) Date of filing: **18.03.87**

(54) Capacitance switching device for keyboard.

(30) Priority: **27.03.86 JP 69358/86**

(43) Date of publication of application:
**30.09.87 Bulletin 87/40**

(45) Publication of the grant of the patent:
**03.06.92 Bulletin 92/23**

(84) Designated Contracting States:
**DE FR GB IT NL**

(56) References cited:
**DE-A- 3 424 771**
**US-A- 4 659 879**

**PATENT ABSTRACTS OF JAPAN, vol. 9, no. 75 (E-306)[1798], 4th April 1985; & JP-A-59 208 938**

(73) Proprietor: **BROTHER KOGYO KABUSHIKI KAISHA**
**35, 9-chome, Horita-dori Mizuho-ku**
**Nagoya-shi, Aichi-ken(JP)**

(72) Inventor: **Isao, Mochizuki**
**Sakai Nannocho**
**Kaizu-gun Gifu-Pref.(JP)**

(74) Representative: **Patentanwälte RUFF, BEIER und SCHÖNDORF**
**Neckarstrasse 50**
**W-7000 Stuttgart 1(DE)**

## Description

### BACKGROUND OF THE INVENTION

#### 1. Field of the Invention

The present invention generally relates to a capacitance switching device for a keyboard, and particularly relates to a capacitance switching device of the membrane switch type used for a keyboard or the like.

#### 2. Description of the Prior Art

Conventionally, there has been proposed a capacitance switching device for a keyboard (hereinafter referred to as "a capacitance keyboard switching device") in which the switching operation is performed by a change in electrostatic capacity between a movable electrode and a fixed electrode caused when a key on the keyboard is depressed.

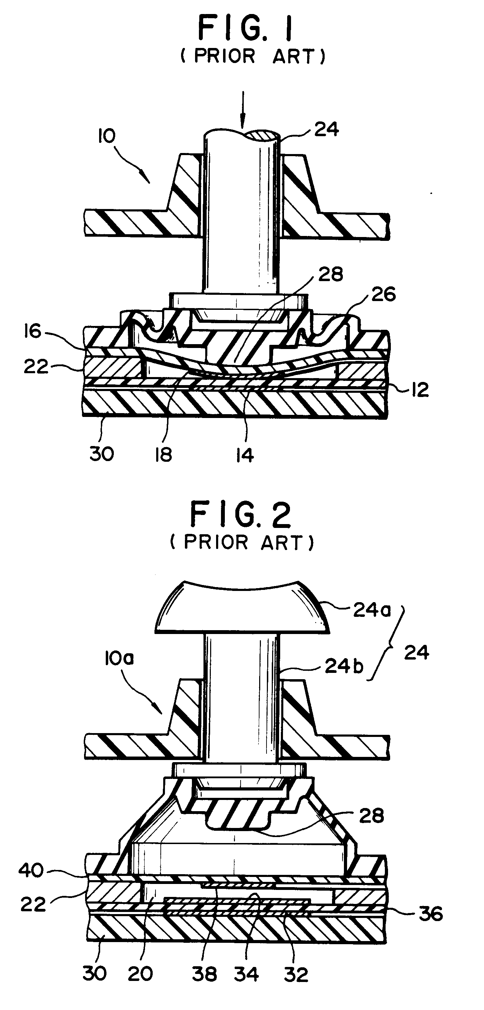

As the capacitance keyboard switching device of the type as described above, there have been proposed capacitance keyboard switching devices of the membrane switch type as shown in Figs.1 and 2.

Fig.1 shows a main part of a conventional capacitance keyboard switching device 10 in a keyboard. In the drawing, a fixed electrode 14 is provided on a back or lower surface of a first insulating film 12 which is the base side of the capacitance keyboard switching device 10, and a movable electrode 18 is provided on a back or lower surface of a second insulating film 16 disposed above the first insulating film 12, the fixed electrode 14 and the movable electrode 18 being disposed in opposition to each other in a switching opening portion 20 of a spacer 22 with a certain gap defined by the spacer 22. In the thus arranged capacitance keyboard switching device 10, when a key 24 (partially shown) is depressed, a depressing portion 28 of a movable electrode depressing member 26 is lowered to thereby depress the second insulating film 16 together with the movable electrode 18, so that the movable electrode 18 is made to come close to the fixed electrode 14 through the first insulating film 12 so as to increase an electrostatic capacity of a capacitor formed between the fixed electrode 14 and the movable electrode 18 to a predetermined value to thereby allow an externally applied AC signal applied to pass therethrough. The key 24 is constituted by a key top 24a, a cylindrical portion 24b, and an abutment portion 24c as shown in Fig.2. The reference numeral 30 designates a bottom portion of a casing of the keyboard. It is a matter of course that the keyboard is provided with numbers of such capacitance keyboard switching devices while only one capacitance switching device is illustrated in the drawing. This applies in the following cases.

In the thus arranged capacitance keyboard switching device, however, the second insulating film 16 is deformed to curve at the lower surface portion circumferentially outside the circumference of the depressing portion 28 when the second insulating film 16 is depressed by the depressing portion 28, so that the movable electrode 18 abuts on the upper surface of the first insulating film 15 in the state where the movable electrode 18 is partially bent. As a result, in the capacitor formed by both the electrodes 16 and 18 with the first insulating film 15 interposed therebetween, the abutment area where the electrodes 16 and 18 are in contact with each other with the first insulating film 15 interposed therebetween may vary depending on the depressed state of the key 1, so that an electrostatic capacity formed by the capacitor varies, resulting in a disadvantage in reliability in switching operation.

In order to eliminate the foregoing disadvantage, there has been proposed an improved capacitance keyboard switching device as disclosed in Japanese Patent Unexamined Publication No.117512/1985, in which a first fixed electrode is provided between a movable electrode and a second fixed electrode to thereby form a capacitor having a fixed capacitance between the first and the second fixed electrode and a switching operation is performed in the state where the movable electrode is caused to abut on the first fixed electrode to thereby prevent such a phenomenon that the electrostatic capacity is varied depending on the condition of the key depressing operation.

Fig.2 shows such an improved capacitance keyboard switching device 10a. In the drawing, a first insulating film 36 is disposed in opposition to a second insulating film 40 with a predetermined gap therebetween defined by a spacer 22, a first fixed electrode 32 and a second fixed electrode 34 are respectively provided on the lower and upper surfaces of the first insulating film 36 in opposition to each other, and a movable electrode 38 is provided on the lower surface of the second insulating film 40 in opposition to the second fixed electrode 34. In the thus arranged capacitance keyboard switching device 10a, when depressed/released by a key 24 the depressing portion 28 comes down/up within an opening portion 20 of the spacer 22 to thereby cause the movable electrode 38 to directly contact with/separated from the second fixed electrode 34.

In those conventional capacitance keyboard switching devices described above, however, it is necessary to provide two insulating films, that is, a first insulating film provided with one or two fixed electrodes and e second insulating film provided with a movable electrode, and further it is necessary to provide the spacer so as to form a gap for performing a switching operation.

Therefore, there has been a problem that the capacitance keyboard switching device is made complicated in structure to increase in manufacturing cost thereof.

The DE-OS 34 24 771 describes a keyboard switching device with a curved keyboard including a condensor switch. The movable electrode is fixed to a reversed cup-like rubber spring which itself only is adjacent but not fixed to the bottom plate of the key. Therefore an exact and controlled axial movement downward of the rubber spring could not be guaranteed. Additional the therein disclosed movable electrode consists of several parts which induces high costs.

The Patent Abstracts of Japan, Vol. 9, No. 75 (E-306) [1798], 4th April 1985 discloses an electrostatic capacity type keyboard switch with a mobile electrode, positioned opposite of a pair of switch terminals, which are simultaneously a fixed electrode of the condensor. This arrangement of fixed electrodes together with the position of the movable electrode causes a reduction in the flexibility to arrange circuit patterns for connecting fixed electrodes to each other as well as other necessary circuit patterns. This implies that the space between the patterns decreases at an area of high pattern density, thereby resulting in higher possibility of crosstalk and noise.

## SUMMARY OF THE INVENTION

It is therefore an object of the present invention to eliminate the foregoing disadvantage in the prior art.

It is another object of the present invention to provide a capacitance keyboard switching device, in which no variation depending on the depressing state is caused in electrostatic capacity when a switching device is closed to thereby ensure a stable switching operation, and which is simple in structure and reduced in cost.

In order to attain the above objects, according to an aspect of the invention, the capacitance keyboard switching device comprises a first fixed electrode formed on a lower surface of an insulating film, a first conductor pattern leading from the first fixed electrode, a second fixed electrode formed on an upper surface of the insulating film in opposition to the first fixed electrode so as to form an electrostatic capacity between the first fixed electrode and the second fixed electrode, a second conductor pattern leading from the second electrode, a movable electrode, a pair of switching electrodes formed so as to be separated from and opposite to each other part-way along the second conductor pattern to thereby electrically separate the second conductor pattern into two parts, the movable electrode being so arranged as to come into contact with and separate from the switching electrodes to make and break therebetween.

In the thus arranged capacitance keyboard switching device according to the present invention, in the state where a key is not depressed yet, a switching device is in its opened state.

When the key is depressed, the movable electrode is moved downward to come into contact with the pair of switching electrodes, so that the switching electrodes are electrically connected to each other through the movable electrode so as to allow an AC signal to be transferred from an external circuit to the same through the first conductor pattern, the first fixed electrode, an electrostatic capacity of the capacitor formed between the first and second fixed electrodes, the second fixed electrode, and the second conductor pattern, and vice versa.

The above and other objects, features, and advantages of the present invention will be more apparent from the following description with reference to the accompanying drawings.

## BRIEF DESCRIPTION OF THE DRAWINGS

Fig.1 is a cross section showing an example of the conventional capacitance keyboard switching device in the depressed state;

Fig.2 is a cross section of another example of the conventional capacitance keyboard switching device in the not-depressed state;

Fig.3 is a cross section showing an embodiment of the capacitance keyboard switching device according to the present invention; and

Fig.4 is a perspective view of the same embodiment of Fig.3.

## DETAILED DESCRIPTION OF THE PREFERRED EMBODIMENT

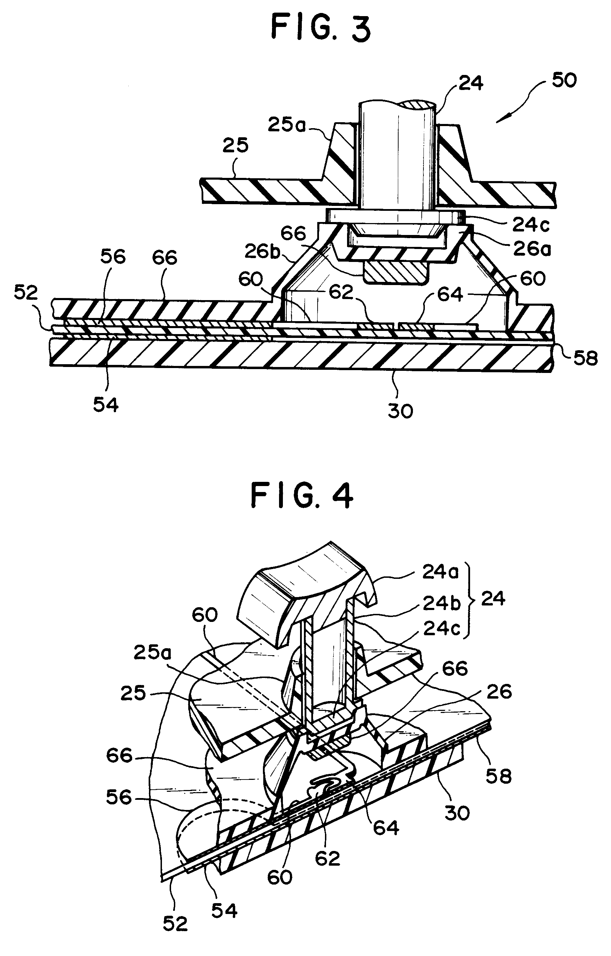

Referring now to Figs.3 and 4, an embodiment of the capacitance keyboard switching device according to the present invention will be described hereunder.

The main part of this capacitance keyboard switching device is constituted by an insulating film 52 provided with a first and a second fixed electrode 54 and 56, a first and a second conductor pattern 58 and 60, and a pair of switching electrodes 62 and 64, and a movable electrode 66 fixed to a rubber spring 26 so as to be caused to come into contact with or separated from the pair of switching electrodes 62 and 64. The rubber spring 26 abuts at its upper surface portion against the lower surface of a key 24. The key 24 is constituted by a key top portion 24a, a cylindrical portion 24b, and an abutment portion 24c, and arranged to be vertically movably guided at the cylinder portion 24b by a key guide portion 25a of an upper insulating frame 25 of a keyboard. The lower surface of the insulating film 52 is supported by a base insulating frame 30 of the keyboard 12.

The insulating film 52 is made of a flexible material or a hard material, for example, a polyester film or a polycarbonate film. The first fixed electrode 54 and the first conductor pattern 58 led from the first fixed electrode 54 are formed on the lower surface of the insulating film 52 through printing or etching process. The second fixed electrode 56, the second conductor pattern 60 led from the second fixed electrode 56, and the pair of switching electrodes 62 and 64 are formed on the upper surface of the insulating film 52 through printing or etching process in such a manner that the second fixed electrode 56 is disposed in opposition to the first fixed electrode 54, and the pair of switching electrodes 62 and 64 are formed to be separated from and opposite to each other in the vicinity of the second fixed electrode 56 and on a halfway portion of the second conductor pattern 60 to thereby electrically separate the second conductor pattern 60 into two parts.

The rubber spring 26 of a high molecular material having elasticity, for example, rubber, is formed integrally with a sheet member 68 and in a shape of a reversed cup, and mounted on the upper surface of the insulating film 52 for performing key switching action. The rubber spring 26 is composed of a top portion 26a having an annular rim portion which abuts on the lower surface of the abutment portion 24c of the key 24, and a thin conical portion 26b circumferentially formed under the top portion 26a. The substantially cylindrical movable electrode 66 is provided on the lower surface of the top portion 26a.

The movable electrode 66 is made of conductive rubber in this embodiment, and arranged to abut on the switching electrodes 62 and 64 when the rubber spring 26 is depressed by the key 24 to thereby lower the movable electrode 66 so as to electrically connect the switching electrodes 62 and 64 through the movable electrode 66.

The capacitance keyboard switching device 50 is arranged such that the respective centers of the pair of switching electrodes 62 and 64 on the insulating film 52m, and the center of the movable electrode 66, and the respective axial lines of the rubber spring 26 and the key 24 are made to exist on one and the same axial line. The first and second conductor patterns 58 and 60 are connected to an external electric circuit (not shown) so that the keying operation of the keyboard is detected by the external electric circuit by means of a change in electrostatic capacity between the first and second conductor patterns 58 and 60 caused in response to the make/break state between the pair of switching electrodes 62 and 64.

Next, the operation of the thus arranged capacitance keyboard switching device will be described.

When the key 24 is depressed, the rubber spring 26 is in turn depressed, so that the movable electrode 66 is moved downward.

At this time, the conical portion 26b of the rubber spring 26 is deformed by the depression of the key 24, so that the movable electrode 66 is moved downward while increasing a pressing load. when the key 24 is further depressed, the conical portion 26b is buckled to thereby suddenly decrease the pressing load, and this reaction gives an operator a click feeling.

Immediately after this click point, the movable electrode 66 abuts on the switching electrodes 62 and 64 to electrically connect the electrodes 62 and 64 through the movable electrode 66 so as to allow an AC signal to be transferred from an external circuit to the same through the first conductor pattern 58, the first fixed electrode, an electrostatic capacity of the capacitor formed between the first and second fixed electrodes 54 and 56, the second fixed electrode 56, and the second conductor pattern 60, and vice versa.

When the pressing load by the key 24 is removed, the rubber spring 26 is restored to the original state by elastic recovery force of the rubber spring 26, and the movable electrode 66 is separated from the first and second switching electrodes 62 and 64, so that the electrical connection between the first and second switching electrodes 62 and 64 is removed. As a result, the transfer of the AC signal between the first and the second conductor pattern 58 and 60 is stopped to thereby open the switching device.

As described above, the capacitance keyboard switching device according to the present invention is provided with a first fixed electrode formed on a lower surface of an insulating film, a first conductor pattern led from the first fixed electrode, a second fixed electrode formed on an upper surface of the insulating film in opposition to the first fixed electrode, a second conductor pattern led from the second electrode, a pair of switching electrodes formed so as to be separated from and opposite to each other on a halfway portion of the second conductor pattern to thereby electrically separate the second conductor pattern into two parts, and a movable electrode arranged to be movable so as to come into contact with and separate from the switching electrodes to make and break therebetween. Accordingly, when the movable electrode is made to abut on the pair of switching electrodes, the pair of switching electrodes are electrically connected so as to allow an AC signal to be transferred from an external circuit to the same through the first conductor pattern, the first fixed electrode, an electrostatic capacity of the capacitor formed between the first and second fixed electrodes, the second fixed electrode, and the second conductor pattern, and vice versa. Accordingly, there occurs no variation in capacity owing to a fluctuation in operation state of the key when the switching device is closed to thereby obtain high reliability, so that the ON/OFF operation of the keyboard switching device can be stably performed.

Further, the keyboard switching device uses only one insulating film, so that no spacer is required to reduce the parts in number to make the arrangement of the capacitance keyboard switching device simply and to reduce the manufacturing cost thereof.

Moreover, the fixed electrodes forming the capacitor are not required to be formed below the key, and shapes of the electrodes may be selected to be free, with an effect that the degree of freedom in design of the capacitance keyboard switching device can be increased.

## Claims

1. A capacitance keyboard switching device (50) comprising: a first fixed electrode (54) formed on a lower surface of an insulating film (52); a first conductor pattern (58) leading from said first fixed electrode (54); a second fixed electrode (56) formed on an upper surface (6) of said insulating film (52) in opposition to said first fixed electrode (54) so as to form an electrostatic capacity between said first fixed electrode (54) and said second fixed electrode (56); a second conductor pattern (60) leading from said second electrode (56); and a movable electrode (66), characterized in that a pair of switching electrodes (62, 64) are formed so as to be separated from and opposite to each other part-way along said second conductor pattern (60) to thereby electrically separate said second conductor pattern (60) into two parts and that said movable electrode (66) is arranged so as to come into contact with and separate from said switching electrodes (62, 64) to make and break therebetween.

2. A capacitance keyboard switching device according to Claim 1, further comprising a reversed cup-like rubber spring (26) constituted by a top portion (26a) and a thin conical portion (26b) formed integrally with and below said top portion (26a) and mounted on the upper surface of said insulating film (52), said top portion (26a) being made to abut at its upper surface on a lower surface of a key (24), said movable electrode (66) being mounted on a lower surface of said top portion (26a), so that when said key (24) is manually depressed said movable electrode (66) is lowered by said top portion (26a) to directly come into contact with said switching electrodes (62, 64) to electrically connect said switching electrodes (62, 64) through said movable electrode (66), said rubber spring (26) being capable of restoring its original state when said key (24) is released from depression.

3. A capacitance keyboard switching device according to Claim 1 or 2, in which said movable electrode (66) is made of an electrically conductive rubber material.

## Revendications

1. Dispositif de commutation capacitif de claviers (50) comprenant : une première électrode fixe (54) formée sur une surface inférieure d'un film isolant (52) ; une première configuration de conducteurs (58) sortant de ladite première électrode fixe (54) ; une seconde électrode fixe (56) formée sur une surface supérieure (6) dudit film isolant (52) face à ladite première électrode fixe (54) de manière à constituer un condensateur électrostatique entre ladite première électrode fixe (54) et ladite seconde électrode fixe (56) ; une seconde confifuration de conducteur (60) partant de ladite seconde électrode (56) ; et une électrode mobile (66), caractérisé en ce que les deux électrodes de commutation (62, 64) sont formées de manière à être séparées l'une de l'autre et à se trouver face à face en un certain point le long de ladite configuration du second conducteur (60) afin de séparer électriquement de cette façon ladite seconde configuration de conducteur (60) en deux parties, et en ce que ladite électrode mobile (66) est disposée de façon à venir en contact avec lesdites électrodes de commutation (62, 64) et à se séparer de ces dernières pour établir le contact et l'interrompre entre elles.

2. Dispositif de commutation capacitif de claviers selon la revendication 1, comportant en outre un ressort en caoutchouc en forme de coupelle renversée (26) constitué par une portion supérieure (26a) et une portion connique mince (26b) faisant partie intégrante de ladite portion supérieure (26a) et au-dessous de cette dernière et montées sur la surface supérieure dudit film isolant (52), ladite portion supérieure (26a) étant construite pour venir en butée par sa surface supérieure sur une surface inférieure d'une touche (24), ladite électrode mobile (66) étant montée sur une surface inférieure de ladite portion supérieure (26a) de manière qu'au moment où on appuie manuellement sur ladite touche (24) ladite électrode mobile (66) soit abaissée par ladite portion supérieure (26a) de manière à venir directement en contact avec lesdites électrodes de commutation (62, 64) afin de brancher électriquement lesdites électrodes de commutation (62, 64) par l'intermédiaire de ladite électrode mobile (66), ledit ressort en caoutchouc (26) étant capable de reprendre son état d'origine quand ladite touche (24) est dégagée de toute action d'abaissement.

3. Dispositif de commutation capacitif de claviers selon la revendication 1 ou 2, dans lequel ladite électrode mobile (66) est fabriquée en un matériau de caoutchouc électriquement conducteur.

**Patentansprüche**

1. Eine kapazitive Tastatur-Schaltvorrichtung umfassend: eine erste feste Elektrode (54), die an einer unteren Oberfläche eines isolierenden Filmes (52) angeordnet ist; ein erstes Leitermuster (58), das von der ersten festen Elektrode (54) wegführt; eine zweite feste Elektrode (56), die auf einer oberen Oberfläche (6) des isolierenden Filmes (52) gegenüber der ersten festen Elektrode (54) angeordnet ist, um einen elektrostatischen Kondensator zwischen der ersten festen Elektrode (54) und der zweiten festen Elektrode (56) zu bilden; ein zweites Leitermuster (60), das von der zweiten Elektrode (56) wegführt; und eine bewegliche Elektrode (66), dadurch gekennzeichnet, daß ein Paar Schaltelektroden (62, 64) voneinander getrennt und einander gegenüberliegend, teilweise entlang des zweiten Leitermusters (60) ausgebildet sind, um dadurch das zweite Leitermuster (60) elektrisch in zwei Teile zu trennen und daß die bewegliche Elektrode (66) angeordnet ist, um mit den Schaltelektroden (62, 64) in Kontakt zu kommen und davon getrennt zu sein, um zu überbrücken und zu unterbrechen.

2. Eine kapazitive Tastatur-Schaltvorrichtung nach Anspruch 1, ferner umfassend eine umgekehrt schalenförmige Gummifeder (26), die aus einem oberen Abschnitt (26a) und einem dünnen konischen Abschnitt (26b), der einstückig mit und unter dem oberen Abschnitt (26a) vorgesehen ist, besteht und auf der oberen Oberfläche des isolierenden Filmes (52) befestigt ist, wobei der obere Abschnitt (26a) zum Anschlag mit seiner oberen Oberfläche an einer unteren Oberfläche einer Taste (24) ausgebildet ist, wobei die bewegliche Elektrode (66) an einer unteren Oberfläche des oberen Abschnitts (26a) befestigt ist, so daß, wenn die Taste (24) manuell betätigt ist, die bewegliche Elektrode (66) durch den oberen Abschnitt (26a) abgesenkt wird, um in direkten Kontakt mit den Schaltelektroden (62, 64) zu kommen, um die Schaltelektroden (62, 64) elektrisch durch die bewegliche Elektrode (66) miteinander zu verbinden, wobei die Gummifeder (26) geeignet ist, in ihren Ursprungszustand zurückzukehren, wenn der Druck von der Taste (24) gelöst ist.

3. Eine kapazitive Tastatur-Schaltvorrichtung nach Anspruch 1 oder 2, wobei die bewegliche Elektrode (66) aus einem elektrisch leitfähigen Gummimaterial hergestellt ist.

# F I G. I
## ( PRIOR ART )

# F I G. 2
## ( PRIOR ART )

# FIG. 3

# FIG. 4